# EUROPEAN PATENT APPLICATION

(11) **EP 2 315 328 A2**
(43) Date of publication of application: **27.04.2011**
(21) Application number: 10013817.1
(22) Date of filing: 20.10.2010
(51) Int. Cl.: H02H 7/20, H01L 31/02

(54) **String and system employing direct current electrical generating modules and a number of string protectors**

(30) Priority: 20.10.2009 US 582367
(71) Applicant: Eaton Corporation, Cleveland Ohio 44114-2584 (US)
(72) Inventor: Luebke, Charles J., Sussex, WI 53089 (US); Hastings, Jerome K., Sussex, WI 53089 (US); Pahl, Birger, Milwaukee, WI 53211 (US); Zuercher, Joseph C., Brookfield, WI 53005 (US); Yanniello, Robert, Asheville, NC 28803 (US)
(74) Representative: Wagner, Karl H.

(57) **Abstract**

A string includes direct current electrical generating modules electrically connected in series to form a first end and a remote second end. A power line is electrically connected to one DC EGM at the first end. A return line is electrically connected to another DC EGM at the remote second end. A first string protector is in the power line of the string, and a second SP is in the return line of the string at the remote second end. One of the first and second SPs includes a number of an over current protector, an arc fault protector, a reverse current protector and a ground fault protector. The other one of the first and second SPs includes a number of an over current protector, an arc fault protector, a reverse current protector, a ground fault protector, and a remotely controlled switch in series with the power or return lines.

## Description

### BACKGROUND

### Field

The disclosed concept pertains generally to strings and, more particularly, to such strings including a plurality of direct current electrical generating modules, such as, for example, photovoltaic electrical generating modules. The disclosed concept also pertains to systems, single strings, multiple strings that make an array, and multiple arrays such as string arrays, including a number of strings having a plurality of direct current electrical generating modules.

### Background Information

It is believed that there is no known mechanism in photovoltaic (PV) (e.g., photovoltaic; solar electric) systems to stop strings or string arrays from generating energy under a short circuit fault (e.g., without limitation, a parallel arc), which can result in a fire. For example, fuses at the load end of a string do not prevent this fault. For example, arcs consume energy that does not go to an inverter or load.

Known practice places a protective device (i.e., a fuse) at the load end of a string, in one feed conductor (e.g., wire; typically the positive wire) to protect against back feed conditions and back feed shorts. Depending on the manufacturer, either the positive or negative feed wire will contain a protective device (i.e., a fuse). Depending on the local building codes, the system may have a ground connection or may be un-grounded. Some known combiner boxes include fuses on both conductors for ungrounded systems at the feed end but not at the remote end. It is believed that protective devices are not used at the PV generating modules, at the remote end of a string, or in the return conductor. It is believed that all of the connecting feed conductors between the PV generating modules and the return conductors are unprotected from arcing events or short circuits of all kinds.

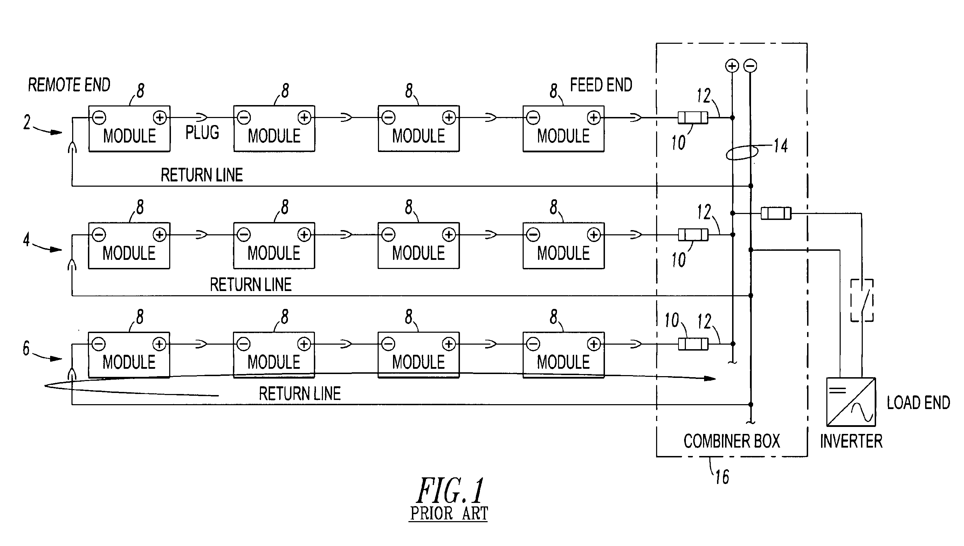

Figure 1 shows several parallel strings 2,4,6 of series-connected direct current (DC) electrical generating modules 8 (e.g., PV generating modules) with a protective device 10 located in the positive conductor 12 of each string. This protective device 10 is a fuse and only protects against a reverse over current when the corresponding string 2,4,6 shorts and is back fed by the other PV strings which are bussed together at the main DC bus 14) in the combiner box 16.

It is known to employ fuses for over current protection and diodes to block reverse current. It is believed that known strings and arrays of DC electrical generating modules do not provide series or parallel arc fault protection.

There is room for electrical safety improvement in strings including a plurality of direct current electrical generating modules.

There is also room for improvement in systems, such as string arrays, including strings having a plurality of direct current electrical generating modules.

### SUMMARY

These needs and others are met by embodiments of the disclosed concept, which detect arcing in a series-connected string of direct current electrical generating modules and interrupt the flow of current in the event that, for example and without limitation, an "in-circuit" arc (commonly referred to as a series arc) or a "short circuit" arc (commonly referred to as a parallel arc) occurs. This also provides protection from other shorts for the conductors and direct current electrical generating modules in such strings, and for the conductors leading from the generating string to an electrical combiner box where currents from adjacent strings are combined and terminated. This mitigates the potential electrical fire hazard in an otherwise unprotected string of direct current electrical generating modules.

In accordance with one aspect of the disclosed concept, a string comprises: a plurality of direct current electrical generating modules electrically connected in series to form a first end and a remote second end; a power line electrically connected to one of the plurality of direct current electrical generating modules at the first end; a return line electrically connected to another one of the plurality of direct current electrical generating modules at the remote second end; and a string protector in the power line of the string, the string protector comprising a number of an arc fault protector, a reverse current protector and a ground fault protector.

In accordance with another aspect of the disclosed concept, a string comprises: a plurality of direct current electrical generating modules electrically connected in series to form a first end and a remote second end; a power line electrically connected to one of the plurality of direct current electrical generating modules at the first end; a return line electrically connected to another one of the plurality of direct current electrical generating modules at the remote second end; and a string protector in the return line of the string at the remote second end, the string protector comprising a number of an over current protector, an arc fault protector, a reverse current protector and a ground fault protector.

In accordance with another aspect of the disclosed concept, a string comprises: a plurality of direct current electrical generating modules electrically connected in series to form a first end and a remote second end; a power line electrically connected to one of the plurality of direct current electrical generating modules at the first end; a return line electrically connected to another one of the plurality of direct current electrical generating modules at the remote second end; a first string protector in the power line of the string; and a second string protector in the return line of the string at the remote second end, wherein one of the first string protector and the second string protector comprises a number of an over current protector, an arc fault protector, a reverse current protector and a ground fault protector, and wherein the other one of the first string protector and the second string protector comprises a number of an over current protector, an arc fault protector, a reverse current protector, a ground fault protector, and a remotely controlled switch in series with the power line or the return line.

At least one of the first string protector and the second string protector may be structured to monitor or report current flowing in the power line or the return line of the string.

The second string protector may be located in a remote combiner box or may be disposed at the remote second end.

The second string protector may be structured to measure current and voltage generated by such another one of the plurality of direct current electrical generating modules regardless whether such another one of the plurality of direct current electrical generating modules is isolated from the string.

The first string protector and the second string protector may be structured to trip open the power line and the return line, respectively, of the string; and the first string protector and the second string protector may be further structured to communicate between each other such that a trip by one of the first string protector and the second string protector causes a trip by the other one of the first string protector and the second string protector.

The one of the first string protector and the second string protector may be structured to trip open the power line and the return line, respectively, of the string; the other one of the first string protector and the second string protector may comprise the remotely controlled switch; and the first string protector and the second string protector may be further structured to communicate between each other such that the trip causes the remotely controlled switch to trip open one of the power line and the return line, such that both of the power line and the return line are opened.

In accordance with another aspect of the disclosed concept, a string comprises: a plurality of direct current electrical generating modules electrically connected in series to form a first end and a remote second end; a power line electrically connected to one of the plurality of direct current electrical generating modules at the first end; a return line electrically connected to another one of the plurality of direct current electrical generating modules at the remote second end; a number of first protectors operatively associated with the power line of the string; and a plurality of second string protectors, each of the plurality of second string protectors being at a corresponding one of the plurality of direct current electrical generating modules, wherein each of the number of first protectors and the plurality of second string protectors comprises a number of an over current protector, an arc fault protector, a reverse current protector and a ground fault protector.

The plurality of direct current electrical generating modules may be photovoltaic electrical generating modules; and such each of the plurality of second string protectors may be structured to monitor photovoltaic electrical generating module current, voltage and illumination at the corresponding one of the photovoltaic electrical generating modules.

Each of the plurality of second string protectors may be structured to isolate the corresponding one of the plurality of direct current electrical generating modules from the string responsive to at least one of the over current protector, the arc fault protector, the reverse current protector and the ground fault protector.

The corresponding one of the plurality of direct current electrical generating modules may include a junction box; and one of the plurality of second string protectors may be integral to the junction box.

The corresponding one of the plurality of direct current electrical generating modules may include a junction box; and one of the plurality of second string protectors may be operatively associated with the junction box.

The number of first protectors may be selected from the group consisting of: a third string protector in the power line between one of the plurality of direct current electrical generating modules and a direct current power bus, a fourth protector in a main feed between the direct current power bus and an inverter, and a fifth string protector in a combiner box.

Each of the plurality of second string protectors may be structured to communicate a status thereof to a remote location, which can determine a status of each of the plurality of direct current electrical generating modules.

A number of the number of first protectors operatively associated with the power line of the string may be structured to communicate a status thereof to the remote location, which can further determine a status of the string.

In accordance with another aspect of the disclosed concept, a system comprises: a first combiner box; a second combiner box; a plurality of strings extending between the first combiner box and the second combiner box, each string of a plurality of the plurality of strings comprising: a plurality of direct current electrical generating modules electrically connected in series to form a first end and an opposite second end, a power line electrically connected to one of the plurality of direct current electrical generating modules at the first end, a return line electrically connected to another one of the plurality of direct current electrical generating modules at the opposite second end, a first string protector in the power line of such each string, and a second string protector in the return line of such each string at the opposite second end, wherein one of the first string protector and the second string protector comprises a number of an over current protector, an arc fault protector, a reverse current protector and a ground fault protector, and wherein the other one of the first string protector and the second string protector comprises a number of an over current protector, an arc fault protector, a reverse current protector, a ground fault protector and a remotely controlled switch in series with the power line or the return line, wherein, for a plurality of the plurality of strings, one of the first and second combiner boxes is located at the first end, wherein, for a plurality of the plurality of strings, the other one of the first and second combiner boxes is located at the opposite second end, wherein the power line of a plurality of the plurality of strings is located in the first combiner box, and wherein the return line of the last such plurality of the plurality of strings is located in the second combiner box.

A plurality of the first string protector and the second string protector located in the first combiner box may be powered from a direct current bus voltage within the first combiner box; and a plurality of the first string protector and the second string protector located in the second combiner box may be powered from the direct current bus voltage within the second combiner box.

In accordance with another aspect of the disclosed concept, a string comprises: a plurality of direct current electrical generating modules electrically connected in series to form a first end and a remote second end; a power line electrically connected to one of the plurality of direct current electrical generating modules at the first end; a return line electrically connected to another one of the plurality of direct current electrical generating modules at the remote second end; and a plurality of string protectors, each of a plurality of the plurality of string protectors being operatively associated with at least one of the power line, the return line at the remote second end and one of the plurality of direct current electrical generating modules, each of the plurality of the plurality of string protectors comprising a number of an over current protector, an arc fault protector, a reverse current protector and a ground fault protector, wherein one of the plurality of string protectors is structured to determine a normal state of the string and responsively transmit a signal, and wherein another one of the plurality of string protectors is structured to receive the signal and responsively maintain series electrical connection of a corresponding one of the plurality of direct current electrical generating modules with at least another one of the plurality of direct current electrical generating modules.

Such another one of the plurality of string protectors may be structured, when not receiving the signal, to responsively isolate the corresponding one of the plurality of direct current electrical generating modules from at least such another one of the plurality of direct current electrical generating modules.

A plurality of the plurality of string protectors may be structured to determine a normal state of the string and responsively transmit a corresponding signal to others of the plurality of string protectors.

The signal may include an active state corresponding to the normal state of the string and an inactive state corresponding to a fault state of the string; and such another one of the plurality of string protectors may be structured to receive the signal having the normal state and responsively maintain series electrical connection of the corresponding one of the plurality of direct current electrical generating modules with at least such another one of the plurality of direct current electrical generating modules, and may be further structured upon not receiving the signal having the normal state to responsively electrically disconnect the corresponding one of the plurality of direct current electrical generating modules from at least such another one of the plurality of direct current electrical generating modules.

The signal may include an active state corresponding to the normal state of the string and an inactive state corresponding to a fault state of the string; and absence of the signal or attenuation of the signal may indicate a fault of the string.

A plurality of the plurality of string protectors may be structured to report a fault state of the string or health of the string to a remote location; and the remote location may be structured to determine fault location based on which of the plurality of the plurality of string protectors reported the fault state or did not report the heath.

### BRIEF DESCRIPTION OF THE DRAWINGS

A full understanding of the disclosed concept can be gained from the following description of the preferred embodiments when read in conjunction with the accompanying drawings in which:
Figure 1 is a block diagram in schematic form of a plurality of strings of direct current (DC) electrical generating modules with a single protective device for each string located in the positive conductor.
Figures 2A-2C are block diagrams in schematic form of a plurality of strings showing possible faults and their locations in DC power generating circuits.
Figure 3 is a block diagram in schematic form of a first string protector in the positive feed conductor and a second string protector in the return conductor at the remote end of a string in accordance with an embodiment of the disclosed concept.
Figure 4 is a block diagram in schematic form of a string protector at each DC electrical generating module of a plurality of strings in accordance with another embodiment of the disclosed concept.
Figure 5 is a block diagram in schematic form of a string protector at each end of a string with a short circuit in the middle of the string, a string protector at another DC electrical generating module, and communication between the first and second string protectors in accordance with another embodiment of the disclosed concept.
Figure 6 is a block diagram in schematic form of a combiner box at each end for multiple strings and string arrays in accordance with another embodiment of the disclosed concept.
Figure 7 is a block diagram in schematic form of a string protector in accordance with other embodiments of the disclosed concept.
Figure 8 is a block diagram in schematic form of a string including a remote string protector in accordance with another embodiment of the disclosed concept.
Figure 9 is a block diagram in schematic form of a string including a string protector in a combiner box in accordance with another embodiment of the disclosed concept.

### DESCRIPTION OF THE PREFERRED EMBODIMENTS

As employed herein, the term "number" shall mean one or an integer greater than one (*i.e. ,* a plurality).

As employed herein, the term "processor" means a preprogrammed, programmable or dedicated logic analog and/or digital device that can store, retrieve, and process data; a computer; a workstation; a personal computer; a microprocessor; a microcontroller; a microcomputer; a central processing unit; a mainframe computer; a mini-computer; a server; a networked processor; or any suitable processing device or apparatus.

As employed herein, the term "short circuit" means a bolted fault or an arcing fault to the opposite polarity or to ground.

As employed herein, the term "bolted fault" means a solid or direct or suitably low impedance electrical connection to the opposite polarity or to ground, typically resulting in an increase in current flow.

As employed herein, the term "arcing fault to the opposite polarity" means an electrical connection to the opposite polarity through a conductive plasma. For example and without limitation, such arcing faults can include: (1) a metal vapor arc (or spark); (2) a plasma arc that requires a relatively hot ionized conduction path; and (3) arcing over a surface which has suffered from a deterioration of its insulating capability by way of an electrolyte or carbon tracking.

As employed herein, the term "in-circuit arcing fault" or "in-circuit arc" means a sustained arcing break (e.g., a plasma) in series electrical connection(s), internal to a generating module, between plural generating modules, or in electrical circuits running to or from a combiner box or any other electrical junction(s), terminal(s) or connection(s). Here, series means that there is another circuit element (e.g., an inverter) present that prevents the arc from being directly in parallel with the generating module.

As employed herein, the term "open circuit" means a break without arcing in a series circuit electrical connection of a string.

As employed herein, the terms "arc fault circuit interrupter", "AFCI" and "arc fault protector" mean an arc fault detector and a number of DC switches responsive to the arc fault detector.

As employed herein, the term "string" means a series electrical circuit connection of a plurality of electrical generating modules.

As employed herein, the term "string protector" means a protection device for a string and/or an electrical generating module of a string. The string protector includes a number of AFCI, over current, reverse current and/or ground fault protection functions.

As employed herein, the term "combiner box" means a box, an enclosure or another suitable structure where one end of a plurality of strings are fused and/or protected. A combiner box electrically combines in parallel DC currents from several strings.

As employed herein, the term "direct current electrical generating module" means a photovoltaic electrical generating module, a battery or a fuel cell.

As employed herein, the term "power line" generally refers to a power conductor at the feed end of a string.

As employed herein, the term "return line" generally refers to a power conductor extending from the remote end to the feed end of a string.

A photovoltaic string of generating modules is an example of a series circuit electrical connection of a plurality of electrical generating modules. An "in-circuit arc" can occur, for example, when an electrical circuit, comprised of a series circuit electrical connection of a plurality of generating modules, is opened under load creating an arc across a gap that sustains the arc.

A "short circuit arc" can occur, for example, when an alternative (e.g., a change from the "normal" conduction path (e.g., from the return conductor at the inverter, through all the generating modules, to the feed conductor, and back to the inverter)) short circuit path to the opposite polarity or ground is established.

A short circuit can, for example and without limitation, form an alternative and un-wanted electrical path that a conventional protection function cannot detect or protect for currents taking an alternative path, such that excessive currents can cause overheating and arcs can cause fires.

An alternative short circuit path (e.g., such as the above un-wanted electrical path) can result in over currents due to back feed currents from adjacent strings to the short circuit path.

A short circuit path can be established at any point along series-connected electrical generating modules.

A short circuit path can also be established between the return or feed conductors from several strings routed in a common location or raceway, or to a grounded frame, conduit, or conductor.

The disclosed concept is described in association with strings including a plurality of photovoltaic electrical generating modules, although the disclosed concept is applicable to strings and string arrays including a plurality of direct current electrical generating modules.

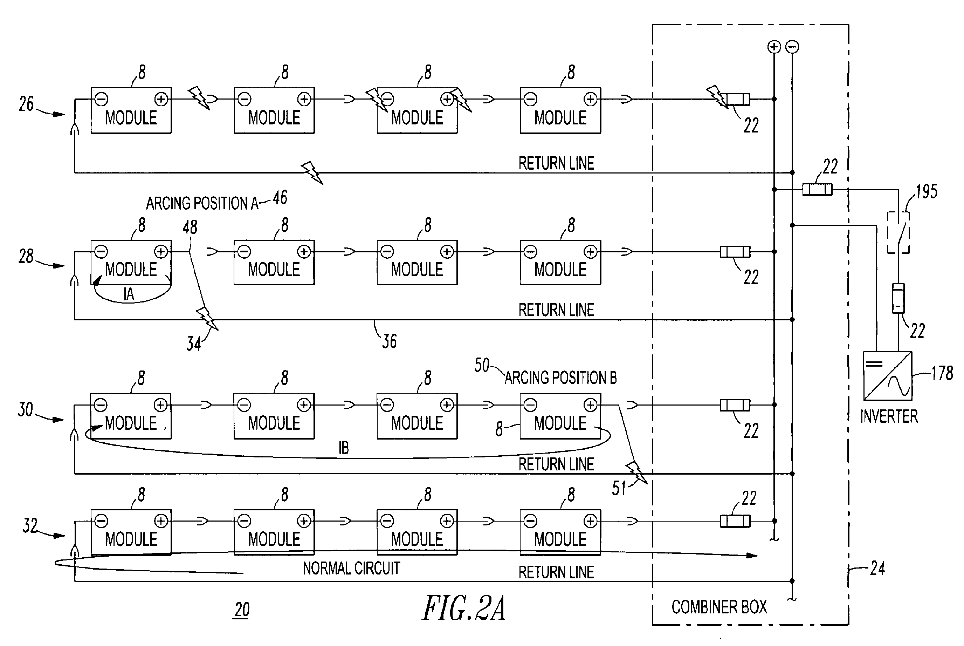

Figures 2A-2C show possible shorting (parallel) and in-circuit-arc faults and their locations in a DC power generating circuit 20. An in-circuit-arc occurs in a series connected string and arises, for example, from a faulty plug or electrical connection, a broken conductor, or a loose fuse clip. An in-circuit-arc can be detected at a single location (e.g., at a protective device 22 in the combiner box 24) and the corresponding string 26,28,30,32 can be opened to stop the arc and protect the circuit 20.

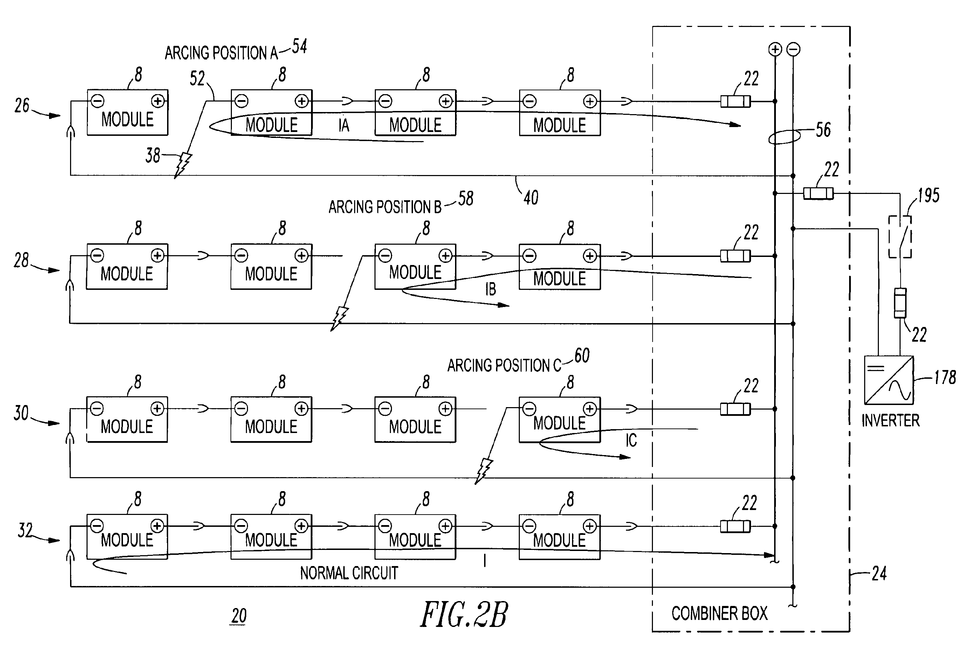

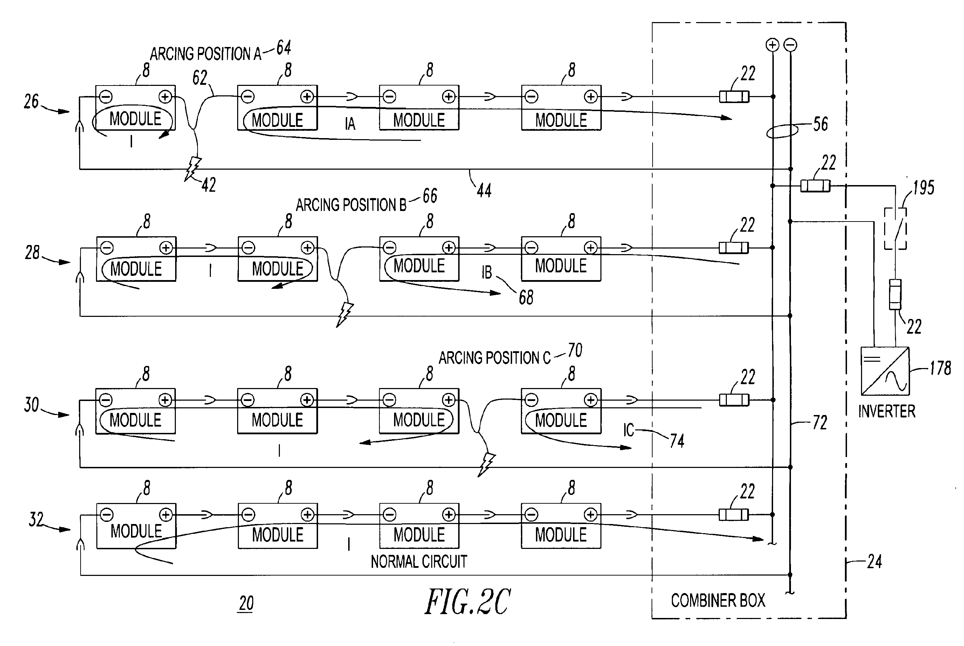

Figure 2A shows a remote short with feed open fault 34, which is a positive polarity broken conductor (from a generating module 8) that contacts the return conductor 36. Figure 2B shows a feed short with remote open fault 38, which is a negative polarity broken conductor (from a generating module 8) that contacts the return conductor 40. Figure 2C shows a pinch short fault 42, which is a pinched connection conductor that contacts the return conductor 44. Arcing can happen, for example, at various positions, such as A 64 (far), B 66 (middle) or C 70 (near).

In Figure 2A, at position A 46, the arc (e.g., a remote short with feed open, where a positive polarity broken conductor 48 contacts the return conductor 36) sees the first generating module 8 (with respect to Figure 2A, at the left of the string 28) voltage and current IA (dependent on the arc impedance), while the remainder of the string 28 is open towards the load (feed end). At position B 50, the arc 51 sees the relatively higher, full length string voltage and current IB, while the remainder of the string 30 is open towards the load (feed end).

In Figure 2B, another arc 38 (e.g., a feed short with remote open, where a negative polarity broken conductor 52 contacts the return conductor 40) is shown. At position A 54, the string 26 is short one generating module 8, and the arc voltage is the difference between the voltage of the main bus 56 and the shorted string voltage, with the string voltage and current IA being reduced (as if it were an in-circuit arc). At position B 58, the string 28 is reverse fed, and the arc voltage is the bus (array) voltage less the IR drop through the forward biased PV diodes (not shown) of the active generating modules 8, with the arc current IB being relatively low and reversed. At position C 60, the last (connected) generating module 8 (with respect to Figure 2B, at the right of the string 30) is reverse fed, and the arc voltage is the bus (array) voltage less the IR drop through the forward biased PV diodes (not shown) of the last generating module 8 (e.g., without limitation, -350 VDC; if there is only one string attached, then the voltage is much less or is extinguished as the inverter adapts its control; in all of these cases, the arc behaves as an in-circuit entity on a shorter string, since the inverter separates the arc from the modules), with the string current IC being relatively high and reversed.

In Figure 2C, another arc 42 (e.g., a pinch short, where an interconnecting conductor 62 between generating modules 8 makes contact with the return line 44) is shown. At position A 64, the parallel fault impedance is shared by the remote module substring, and the feed module substring. The two circulating currents (defined to be positive clockwise with respect to Figure 2C) will subtract and comprise the arc current, which is the remote current less the feed current (from power to return side). For arcing position A 64, there is a minimal effect on the load causing both currents to be positive and the fault current to be the numeric difference between the shorted single module current (relatively larger) and the current drawn by the load (relatively smaller). As the fault proceeds toward the "top" of the power line (load) at positions B 66 and C 70, the load (feed) current reverses (especially for relatively many strings electrically connected making the bus voltage more "stiff") and numerically adds to the remote current, to feed the fault.

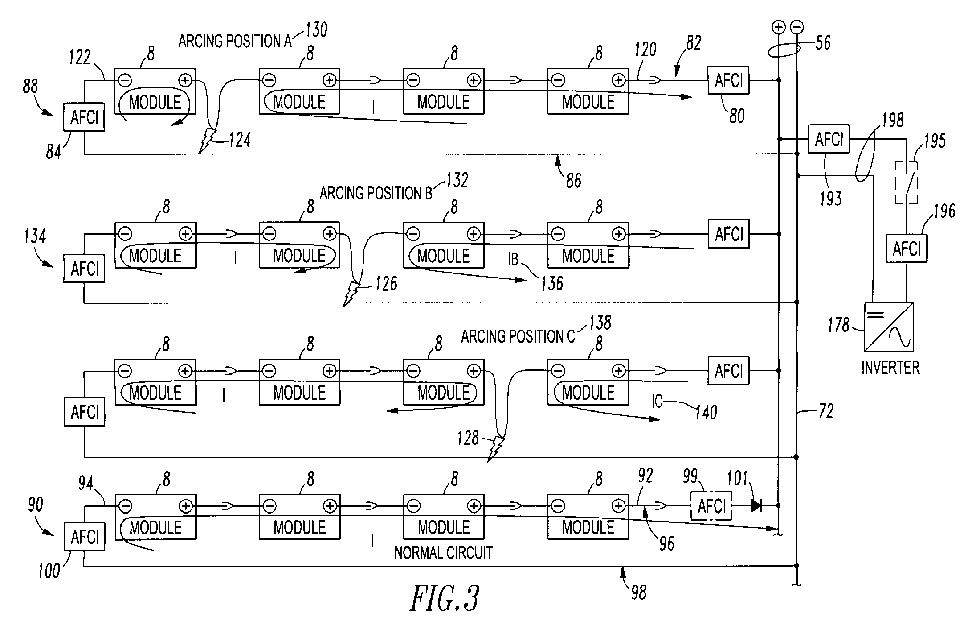

Figure 3 shows a first string protector (SP) 80 (e.g., without limitation, AFCI) in the positive power line 82 (e.g., power conductor) and a second SP 84 (e.g., without limitation, AFCI) in the return line 86 (e.g., return conductor). This configuration can advantageously sense, for example, any single arcing fault in the string 88 regardless of its location.

### Example 1

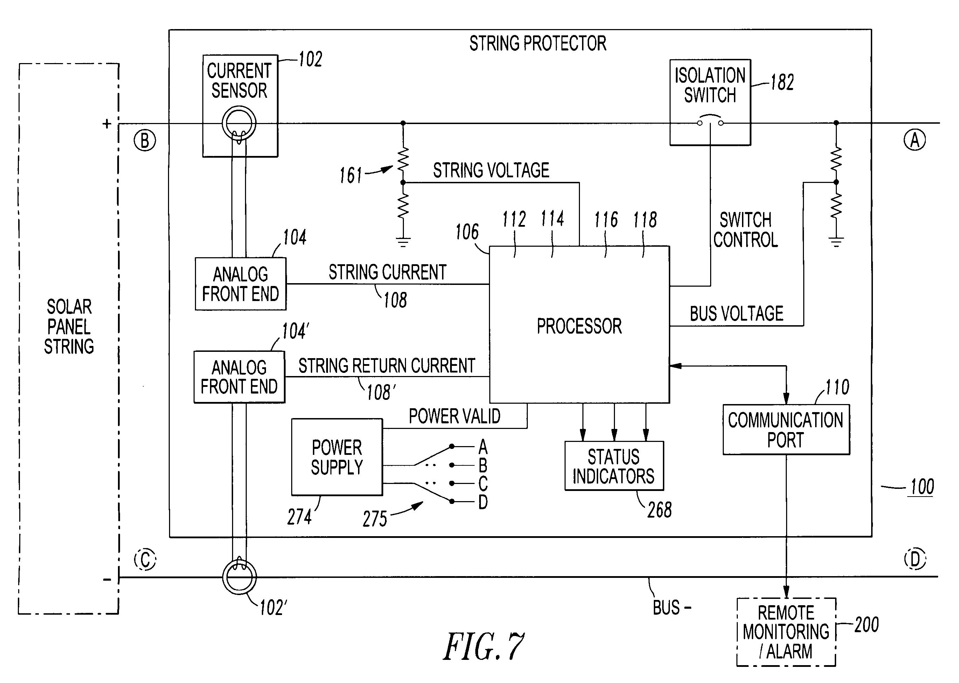

An example string 90 includes a plurality of direct current (DC) electrical generating modules (EGMs) 8 (shown as modules in Figure 3) electrically connected in series to form a first end 92 and a remote second end 94, a power line 96 electrically connected to one of the DC EGMs 8 at the first end 92, a return line 98 electrically connected to another one of the DC EGMs 8 at the remote second end 94, and a SP 100 (e.g., without limitation, AFCI) in the return line 98 of the string 90. As will be described, below, in connection with Figure 7, the SP 100 includes a number of an over current protector, an arc fault protector, a reverse current protector and a ground fault protector.

In this example, an SP 99 (e.g., without limitation, AFCI) (shown in phantom line drawing) in the power line 96 of the string 90 is not required for in-circuit (series) only faults. Preferably, a diode 101 is disposed in the power line 96 at the first end 92 of the string 90. This eliminates the need for the SP 99 (e.g., in a combiner box (not shown)) by blocking reverse current, back-feed current or current sourced from the first end 92 toward the second end 94, and allows the single SP 100 at the second end 94 in the return line 98. This reduces cost by eliminating the SP 99 and allows a relatively lower current interruption rating of the DC switch (not shown) in the SP 100.

### Example 2

The example SP 100 is structured to monitor or report current flowing in the power line 96 of the string 90. For example, as shown in Figure 7, the example SP 100 includes a current sensor 102, an analog front end 104 and a processor 106 (e.g., without limitation, microprocessor) that monitors the sensed string current 108 and reports the same (e.g., without limitation, through communication port 110). The processor 106 includes a number (e.g., one, some or all) of an over current protector routine 112, an arc fault protector routine 114, a reverse current protector routine 116 and a ground fault protector routine 118.

A non-limiting example of DC arc fault detection and protection for the routine 114 is disclosed by U.S. Patent No. 6,577,138, which is incorporated by reference herein.

If DC ground fault protection is employed, then, for example and without limitation, a current sensor 102' and an analog front end 104' provide a string return current 108' to the processor 106 for use by the routine 118. The current sensor 102' is placed on the return line 98. This current sensor 102' electrically connects to analog front end 104' to provide the sensed string return current 108' to processor 106. The routine 118 calculates the difference between currents 108 and 108' to determine if a residual or ground fault current is present.

### Example 3

The example SP 100 (Figure 3) is located at the remote second end 94 of the string 90 with one of the DC EGMs 8. This SP 100 can advantageously be employed for retrofit applications, such that an electrician does not have to go into a combiner box (e.g., 24 of Figures 2A-2C) to install a protective device or rewire. Instead, the electrician simply installs (e.g., without limitation, plugs-in) the SP 100 at the last DC EGM 8 (with respect to Figure 3, at the left of the string 90).

### Example 4

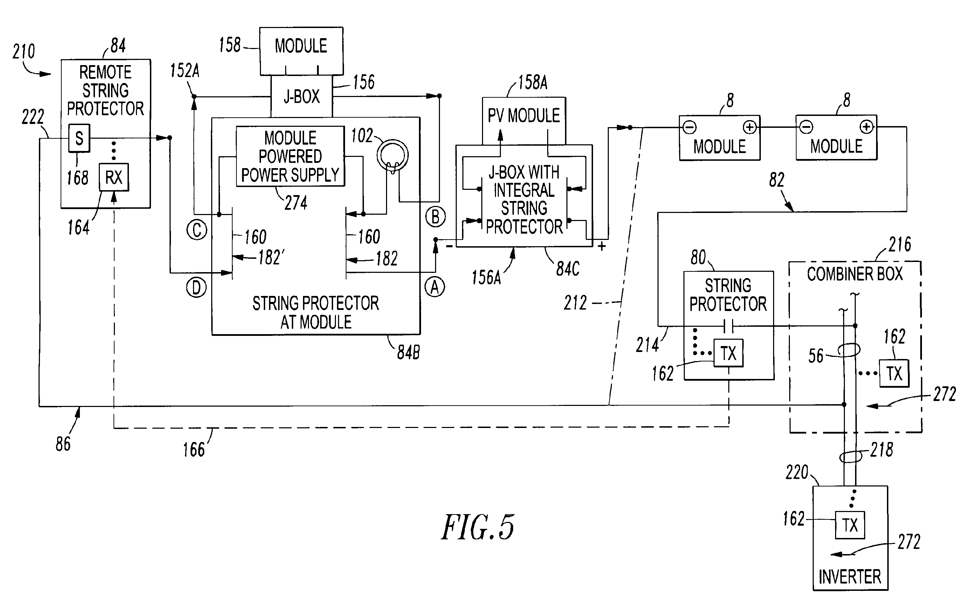

In this example, somewhat similar to Example 1, the string 88 (Figure 3) includes a plurality of DC EGMs 8 electrically connected in series to form a first end 120 and a remote second end 122, the power line 82 electrically connected to one of the DC EGMs 8 at the first end 120, the return line 86 electrically connected to another one of the DC EGMs 8 at the remote second end 122, the first SP 80 in the power line 82 of the string 88, and the second SP 84 in the return line 86 of the string 88. The SPs 80,84, like the SP 100, each include a number of an over current protector, an arc fault protector, a reverse current protector and a ground fault protector. One of the SPs 80,84 can also include a remotely controlled switch (S) 168 in series with the power line 82 or the return line 86, respectively, as will be discussed, below, in connection with Figure 5. Although the example string 88 includes a fault 124 (e.g., without limitation, a short circuit; a parallel arc fault), it will be appreciated from the teachings herein that such fault is abnormal and can be detected and/or reported by one or both of the SPs 80,84.

For example, for an in-circuit-arc 34 as shown in Figure 2A, the arc can be detected at both of the first and second SPs 80,84 of Figure 3. Hence, both ends of the string 88 can be opened by the first and second SPs 80,84. Alternatively, if the second (remote) SP 84 includes the remotely controlled switch 168 (Figure 5), then it can respond to a communication from the first SP 80 and also open the remote end 122 of the string 88.

As another example, for the parallel arcs 42 and 124 shown in Figures 2C and 3, respectively, the arcs can be detected at both of the first and second SPs 80,84. Hence, both ends 120,122 of the string 88 can be opened by the first and second SPs 80,84. Alternatively, if the second (remote) SP 84 includes the remotely controlled switch 168 (Figure 5), then it can respond to a communication from the first SP 80 and also open the remote end 122 of the string 88. In this instance, simply opening the string 88 at only the first SP 80 is inadequate, since the parallel arc 124 would persist due to voltage from the remote generating module 8 (e.g., with respect to Figure 3, at the left of the string 88). Hence, the configuration of Figure 3 is beneficial in detecting and interrupting the parallel arc 124 by opening both ends 120,122 of the string 88.

In the example of Figure 3, the arcs 124,126,128 (e.g., a short-circuit-arcing Type 3 in which an interconnecting conductor between generating modules 8 makes contact with the return line, such as 86) is shown. At position A 130, the string current and voltage are reduced. At position B 132, the last two connected generating modules 8 (e.g., with respect to Figure 3, at the right of the string 134) could be reverse fed, with the string current being relatively high (e.g., IB 136 could be back fed). At position C 138, one generating module 8 (e.g., with respect to Figure 3, at the right of the string 134) is reverse fed with relatively high reverse current, with the arc current being relatively high (e.g., IC 140 is back fed and is relatively very high).

In Figure 3, the SPs 80,84 are positioned in a first conductor, such as the power line 82, and in a second conductor, such as the return line 86. The addition of the second SP 84 in the return line 86 can detect, for example, a single short circuit or arcing event that would be missed by a single protector located only in the positive power line 82. A suitable protective device 196 (e.g., without limitation, arc fault and/or ground fault protector), such as one of the disclosed SPs 80,84,100, can be operatively associated with (e.g., without limitation, located in or at inverter 178; at disconnect switch 195; between disconnect switch 195 and inverter 178) the inverter 178.

### Example 5

The example second SP 84 is disposed at the remote second end 122 of the string 88.

### Example 6

Similar to the SP 100 of Figure 7, at least one of the first and second SPs 80 and 84 can be structured to monitor or report current flowing in the power line 82 or the return line 86, respectively, of the string 88.

### Example 7

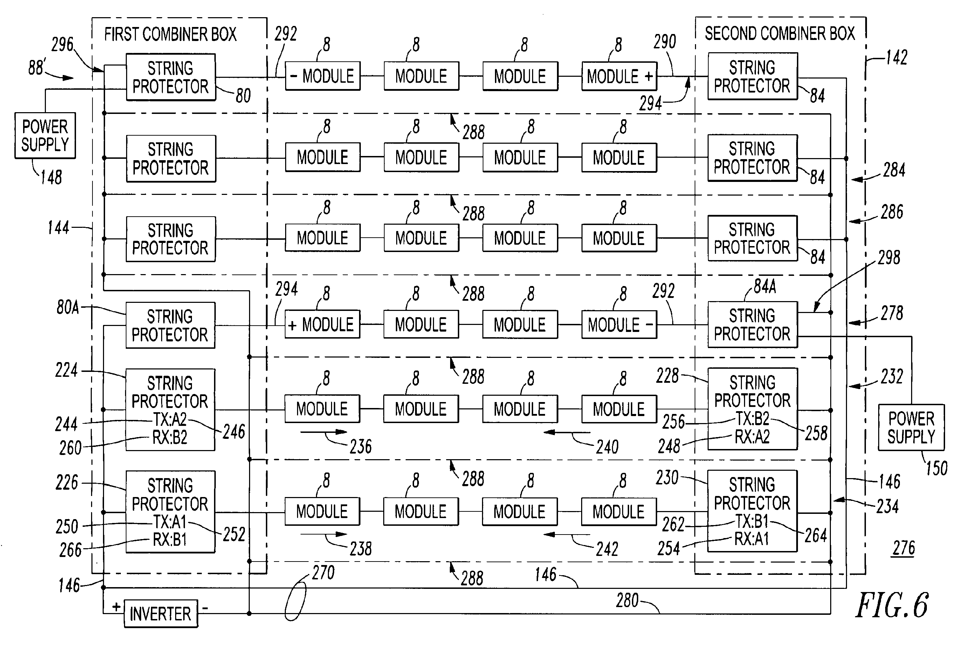

As shown in Figure 6, the second SP 84 can be located in a second (remote) combiner box 142, while the first SP 80 can be located in a first (near) combiner box 144. Otherwise, the string 88' can be the same as or similar to the string 88 of Figure 3.

### Example 8

In Figure 6, a first SP 80A and the second SP 84 are powered from a main direct current bus or power line 146 of the first combiner box 144 and the second combiner box 142, respectively.

### Example 9

The first SP 80 and a second SP 84A are powered from respective power supplies 148 and 150 external to the first combiner box 144 and the second combiner box 142, respectively.

### Example 10

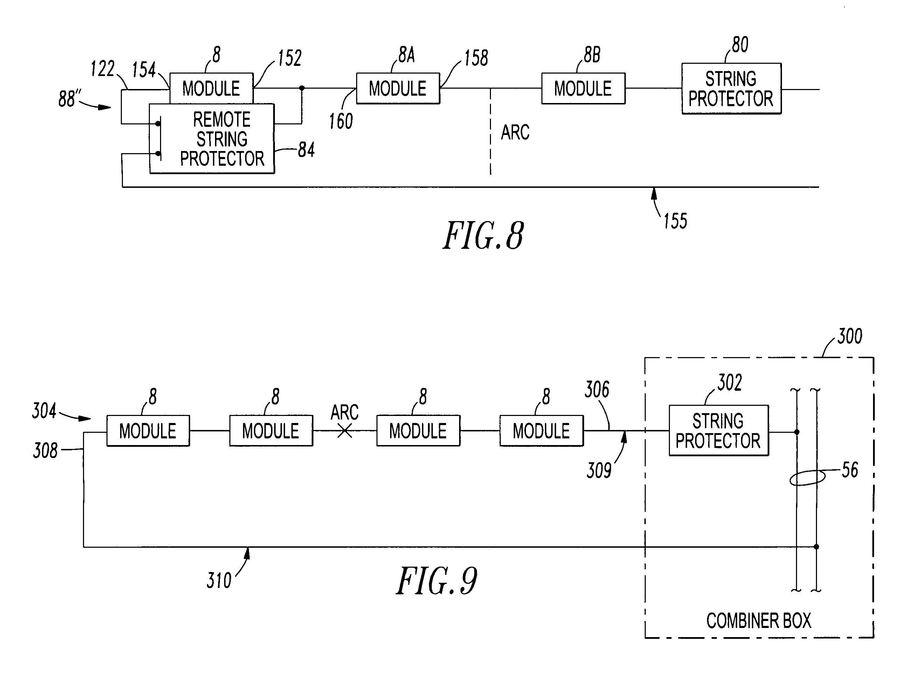

As shown in Figure 8, the second remote SP 84 can be operatively associated with one of the DC EGMs 8 at the remote second end 122 (e.g., without limitation, with respect to Figure 8, with the last DC EGM 8 at the left of the string 88").

### Example 11

The second SP 84 can be powered by one of the DC EGMs 8 at the remote second end 122 (e.g., without limitation, with respect to Figure 8, with the last DC EGM 8 at the left of the string 88").

### Example 12

Figure 8 shows a first DC EGM 8B, a second DC EGM 8A, and the third DC EGM 8, which is at the remote second end 122 of the string 88". The third DC EGM 8 includes a first power terminal 152 and a second power terminal 154 electrically connected by the second SP 84 to the return line 156. The second DC EGM 8A includes a first power terminal 158 and a second power terminal 160 electrically connected to the first power terminal 152 of the third DC EGM 84. The second SP 84 is powered by the third DC EGM 8.

### Example 13

The second SP 84 is structured to interrupt at least one of the first power terminal 152 and the second power terminal 154 of the third DC EGM 8. For example, Figure 8 shows interruption of the second power terminal 154.

### Example 14

The SP 84B of Figure 5 shows interruption of both first power terminal 152A and second power terminal 154A of junction box (J-box) 156 of DC EGM 158 with double pole switch 160.

### Example 15

Similar to the SP 100 of Figure 7, the second SP 84 of Figure 3 or the SPs 84,84B of Figure 5 can isolate the corresponding DC EGM 8 from the respective string 88 or 210 responsive to at least one of the over current protector, the arc fault protector, the reverse current protector and the ground fault protector routines 112,114,116,118.

### Example 16

In the example of Figure 5, the SP 84B is powered by the corresponding DC EGM 158 at the remote end of the string 210 regardless whether the DC EGM 158 is disconnected from the string 210 by the double pole switch 160.

### Example 17

Similar to the SP 100 of Figure 7, the SP 84B can be structured to measure current through the current sensor 102 and voltage generated by the DC EGM 158 through the divider 161 (Figure 7).

For example, if disconnected, the measured current is simply the "test" load inserted by the SP 84B (e.g., by power supply 274), and, if not isolated, the measured current is the load current of the SP 84B plus the current of the string 210.

### Example 18

As will be discussed, below, in connection with Figure 5, the first SP 80 and the second SP 84 of Figure 3 can be structured to trip open the power line 82 and the return line 86, respectively, of the string 88, and, also, to communicate (e.g., without limitation, by employing a power line carrier (PLC) signal (e.g., without limitation, tone); a hard wired communication signal; a wireless communication signal) between each other such that a trip by one of the first and second SPs 80,84 causes a trip by the other one of the first and second SPs 80,84. For example, Figure 5 shows a transmitter (Tx) 162 in the first SP 80, which can communicate with a receiver (Rx) 164 in the second SP 84 using a signal 166. It will be appreciated that the second SP 84 can also include a transmitter (not shown), which can communicate with a receiver (not shown) in the first SP 80 using a signal (not shown).

### Example 19

Further to Example 18, if for example, one of the first and second SPs 80,84 includes a remotely controlled switch (S) 168 (as shown, for example and without limitation, with the second SP 84), then communication of the signal 166 from the first SP transmitter 162 to the second SP receiver 164 can be employed such that the trip by the first SP 80 of the power line 82 causes the remotely controlled switch 168 to trip open the return line 86, such that both of the power line 82 and the return line 86 are opened. It will be appreciated that the remotely controlled switch 168 can be part of the first SP 80, such that communication of the signal (not shown) from the second SP transmitter (not shown) to the first SP receiver (not shown) can be employed such that the trip by the second SP 84 of the return line 86 causes the remotely controlled switch 168 to trip open the power line 82, such that both of the power line 82 and the return line 86 are opened.

### Example 20

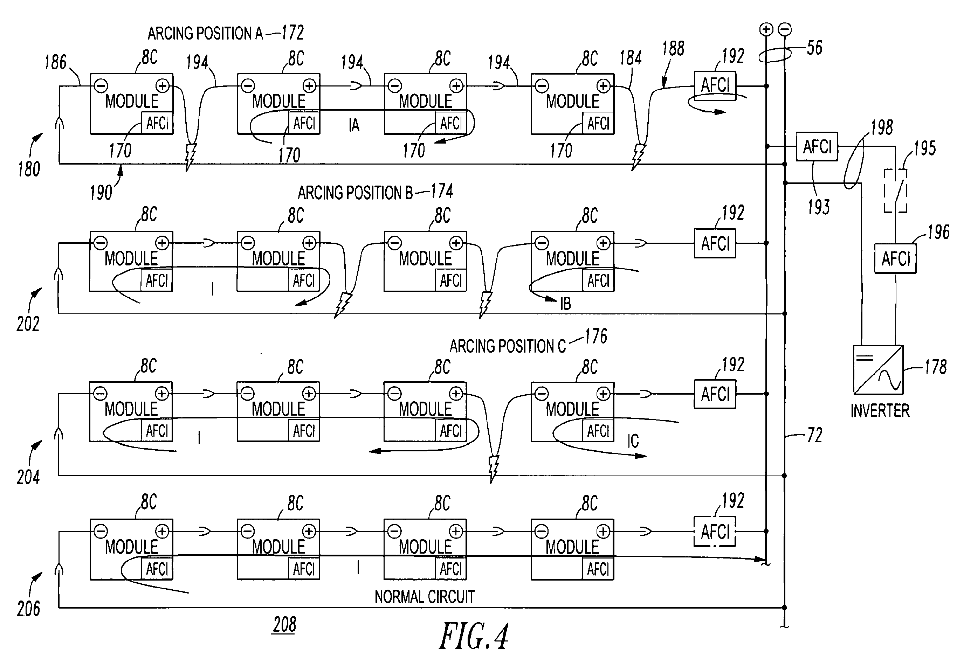

Figure 4 shows a SP 170 (e.g., without limitation, AFCI) at each DC EGM 8C. The plural SPs 170 can sense, for example, short circuit circulating current for a plurality of short circuit paths. In Figure 4, the example arc types and positions A 172, B 174 and C 176 can be the same as or similar to the corresponding arc types and positions of Figure 3. This configuration of Figure 4 provides the maximum protection and can sense, for example, all possible arcing and short circuit events in a string, in one of the DC EGMs 8C and in the connecting conductors between the DC EGMs 8C. By providing SPs 170 at each of the DC EGMs 8C, multiple faults can be sensed. This improves the detection and protection capability of the system 208 and can detect, for example, multiple and simultaneous short circuit or arcing anywhere in the strings 180,202,204,206 or the return lines, such as 190.

The SP 170 in the DC EGM 8C closest to the main bus 56 can sense forward flowing currents under normal conditions and can sense (e.g., without limitation, using the current sensor 102 (Figure 7) in the SP 170) reverse flowing (back feed) currents under any short circuit condition. The ability to sense back feed currents permits such SP to be commanded to terminate the flow of such back feed currents. Back feed currents are unwanted, since they can over heat the generating modules 8C and reduce the net current delivered to the inverter (e.g., central inverter) 178 or its load (not shown). Back feed currents can be greater than the forward feed currents.

A conventional fuse, such as 22 of Figure 2A, is typically sized at 1.56 times the forward short circuit current (Isc) of the string 26. The excess currents can produce a fire hazard. The SP 170 located at the corresponding DC EGM 8C in the string 180 of Figure 4 can sense currents circulating in any one of the alternative short circuit paths at positions A 172, B 174 or C 176. In sensing the faults, this SP 170 can be commanded to terminate the flow of current and clear the fault. Although the fault could still be present, opening the isolation switch 182 (Figure 7) mitigates against and/or prevents hazardous currents from flowing. The disposition of the SPs 170 at each of the generating modules 8C can sense, for example, multiple and simultaneous faults and all possible arcing or short circuit paths of all kinds in the generating string 180 and its connecting conductors.

The example string 180 includes the plurality of DC EGMs 8C electrically connected in series to form a first end 184 and a remote second end 186, a power line 188 electrically connected to one of the DC EGMs 8C at the first end 184, a return line 190 electrically connected to another one of the DC EGMs 8C at the remote second end 186, a number of first protectors 192 (e.g., without limitation, AFCIs) operatively associated with the power line 188 of the string 180, and a plurality of second SPs 170. Each of the second SPs 170 are at a corresponding one of the DC EGMs 8C. Each of the number of first protectors 192 and the plurality of second SPs 170 includes a number of an over current protector, an arc fault protector, a reverse current protector and a ground fault protector. For example, and without limitation, the number of first protectors 192 and the plurality of second SPs 170 can be the same as or similar to the SP 100 of Figure 7. It will be appreciated that this configuration advantageously protects the entire string 180 and all circuit conductors (e.g., such as 194) from multiple and simultaneous shorts and arcing events.

### Example 21

The DC EGMs 8C can be photovoltaic (PV) electrical generating modules, which include the SP 170 structured to monitor PV electrical generating module current, voltage and illumination at the corresponding one of the PV electrical generating modules. Similar to the SP 100 of Figure 7, the SP 170 can monitor current (I) and voltage (V). Illumination can be indirectly calculated by knowing the module voltage and current characteristics.

### Example 22

Each of the second SPs 170 can be structured to disconnect the corresponding one of the DC EGMs 8C from the string 180 responsive to at least one of the over current protector routine 112, the arc fault protector routine 114, the reverse current protector routine 116 and the ground fault protector routine 118 of Figure 7.

### Example 23

Although the second SPs 170 are shown as being integral to (e.g., without limitation, internal to) the corresponding DC EGMs 8C, the second SPs 170 can be operatively associated with the corresponding DC EGMs 8C. For example, as shown in Figure 5, the DC EGM 158A includes a junction box (J-box) 156A and the SP 84C is integral to the junction box 156A.

It will be appreciated that the second remote SP 84 can be configured in the same or similar manner as the SP 84C, which is integral to the junction box 156A of the DC EGM 158A. The second SP 84 is on the DC EGM at the remote end 222 of the string 210. This addresses parallel faults, such as 212, obtains power from the last DC EGM, and provides the ability to detect a fault and open on either or both sides of the DC EGM. If a string protector detects a fault (e.g., without limitation, arc; reverse current) regardless of fault location, it opens the circuit. Preferably, a number of local status indicators, such as 268 of Figure 7, are employed to quickly locate the fault location. Alternatively, or in addition, this function can be provided by remote monitoring/notification to the remote location 200.

### Example 24

As is also shown in Figure 5, the DC EGM 158 includes a junction box 156 and the SP 84B is operatively associated (e.g., coupled to) the junction box 156.

It will be appreciated that the second remote SP 84 can be configured in the same or similar manner as the SP 84B.

### Example 25

In Figure 4, the number of first protectors 192 include the SP 192 in the power line 188 between one of the DC EGMs 8C at the first end 184 of the string 180 and the direct current main bus 56, a main SP 193 in the power line 188 between one of the DC EGMs 8C at the first end 184 of the string 180 and the direct current main bus 56, and another protector 196 in a main feed 198 between the direct current main bus 56 and the inverter 178.

### Example 26

In the same or similar manner as that of the SP 100 of Figure 7, each of the SPs 170 of Figure 4 can be structured to communicate using the communication port 110 a status of the SP 170 and/or of the corresponding DC EGM 8C to a remote location 200 (shown in phantom line drawing), which can determine a status of each of the DC EGMs 8C.

### Example 27

In the same or similar manner as that of the SP 100 of Figure 7, each of the first protectors 192,196 can be structured to communicate using the communication port 110 a status of such protector to the remote location 200 (shown in phantom line drawing), which can determine a status of the corresponding string 180,202,204,206 or of the system 208 of Figure 4.

### Example 28

Figure 5 shows the SPs 80,84 at each end of the string 210 with a short circuit event 212 in the middle of or away from the ends 214,222 the string 210. This configuration provides, for example, detection of an open connection or a broken conductor or arcing in the series connection or a shorting fault. The transmitter 162 (Tx) (e.g., without limitation, tone generator) can be located, for example and without limitation, at any, some or all of the SP 80 at the first end 214 of the string 210, on the main bus 56 within the combiner box 216, or on the main bus 218 at the inverter or load 220. The transmitter 162 (Tx) sends the signal 166 (e.g., without limitation, tone) from the SP 80 down the string 210 to the second SP 84 at the remote second end 222. The SP 84 includes the receiver (Rx) 164, which receives the signal 166.

As long as the second SP 84 receives the proper signal 166 (e.g., without limitation, proper tone), all electrical connections in the string 210 are OK. If the proper signal 166 is lost or corrupted by arcing, then the remote second SP 84 (or the remotely controlled switch 168) will open and clear the fault. For example, the short circuit 212 can attenuate the signal 166 (e.g., without limitation, tone), while an open in any conductor or the return line 86 prevents the signal 166 from properly propagating.

The string 210 includes a plurality of DC EGMs 158,158A,8,8 electrically connected in series to form the first end 214 and the remote second end 222, the power line 82 electrically connected to one of the DC EGMs 8 at the first end 214, the return line 86 electrically connected to another one of the DC EGMs 158 at the remote second end 222 by the SP 84, and a plurality of the SPs 80,84,84B,84C. Although the DC EGMs 158,158A are shown with SPs 84B,84C, respectively, it will be appreciated that one or both of such SPs are not required. Also, although the DC EGMs 8 are shown without a corresponding SP, it will be appreciated that one or both of such DC EGMs 8 can have a corresponding SP.

In Figure 5, each of a plurality of the plural SPs 80,84,84B,84C is operatively associated with at least one of the power line 82, the return line 86 and one of the plural DC EGMs 158,158A. In the same or similar manner as the SP 100 of Figure 7, each of the SPs 80,84,84B,84C includes a number of an over current protector routine 112, an arc fault protector routine 114, a reverse current protector routine 116 and a ground fault protector routine 118. The SP 80 is structured to determine a normal state of the string 210 and responsively transmit the signal 166. The remote second SP 84 is structured to receive the signal 166 and responsively maintain series electrical connection of the corresponding DC EGM 158 with at least one other DC EGM, such as 158A.

### Example 29

The first SP 80 is located adjacent the DC EGM 8 at the first end 214, and the second remote SP 84 is located adjacent another DC EGM 158 at the remote second end 222 of the string 210.

### Example 30

The signal 166 is selected from the group consisting of a wireless signal; a wired signal; and a power line carrier (PLC) signal in a power conductor of the string 210 between the plural DC EGMs 158,158A,8,8.

### Example 31

The SP 84 can be structured, when not receiving the signal 166 (e.g., without limitation, as a result of the short circuit 212; arcing; a broken conductor; the string 210 being open), to responsively disconnect (e.g., without limitation, using the switch (S) 168; using the isolation switch 182 of Figure 7) the corresponding DC EGM 158 from at least the adjacent DC EGM 158A.

### Example 32

As shown in Figure 6, a plurality of the SPs 224,226,228,230 can be structured to determine a normal state of the corresponding string 232 or 234 and responsively transmit a corresponding signal 236,238,240,242 to a number of other SPs. For example, SP 224 includes transmitter (TX) 244 that transmits the signal 236 having tone 246 (A2) to receiver (RX) 248 of SP 228, SP 226 includes transmitter (TX) 250 that transmits the signal 238 having tone 252 (A1) to receiver (RX) 254 of SP 230, SP 228 includes transmitter (TX) 256 that transmits the signal 240 having tone 258 (B2) to receiver (RX) 260 of SP 224, and SP 230 includes transmitter (TX) 262 that transmits the signal 242 having tone 264 (B1) to receiver (RX) 266 of SP 226. It will be appreciated that one, some or all of the DC EGMs 8 of Figure 6 can include a transmitter and/or a receiver.

### Example 33

It will be appreciated that the transmitters 162 of Figure 5 can be part of a string protector, such as SP 80, or a protector for the main bus 56, the main bus 218 or the inverter 220, such that the SPs 80,84,84B,84C and protectors are operatively associated with one of the various DC EGMs 158,158A,8,8, the combiner box 216 or the inverter 220.

### Example 34

The signal 166 of Figure 5 can include an active state corresponding to the normal state of the string 210 and an inactive state corresponding to a fault state of the string 210. One of the SPs, such as SP 84, can be structured to receive the signal 166 having the normal state and responsively maintain series electrical connection of the corresponding DC EGM 158 with at least another one of the DC EGMs, such as 8 at the first end 214, and can be further structured upon not receiving the signal 166 having the normal state to responsively electrically disconnect the corresponding DC EGM 158 from the DC EGM 8 at the first end 214 (e.g., through the return line 86).

### Example 35

For example, by removing the signal 166 (e.g., without limitation, tone), the SP 80 can cause the SP 84 to trip or open. Conversely, by sending or impressing the signal 166 (e.g., without limitation, tone), the SP 80 can cause the SP 84 to reset or close. For example, if a fault (e.g., without limitation, the short circuit 212; an arcing condition) is detected by the SP 80, then it stops sending the signal 166 to the second remote SP 84 to command it to open/trip.

As shown in Figure 6, for PV arrays with multiple strings, such as 232,234, combined to a common main DC bus 270, a modulated tone, such as A2 246 or A1 252, uniquely identifies the specific remote SP, such as 228 or 230, since the modulated tone might propagate to multiple SPs across the main DC bus 270. If the modulated tone is not received by a remote SP, then it assumes there is a fault (e.g., without limitation, short circuit or parallel fault) or open (e.g., without limitation, an in-circuit fault) in the corresponding string, such as 232,234, and turns off.

As shown in Figure 5, if a general tone 272 is generated/broadcast on the main DC bus 56 at the combiner box 216 or at the inverter 220 or load and the first SP 80 opens, then this general tone 272 is not propagated down the string 210 and, also, is not received by the second remote SP 84.

### Example 36

The signal 166 can include an active state corresponding to the normal state of the string 210 and an inactive state corresponding to a fault state of the string 166. The absence or the attenuation of the signal 166 can, thus, indicate a fault of the string 210, such that even if the first SP 80 does not detect the fault, the second remote SP 84 will, at least, sense absence or the attenuation of the signal 166 and trip or open the string 210.

### Example 37

A number of the SPs 80,84,84B,84C can be structured to employ the signal 166 for a maintenance function. For example, by removing the signal 166 (e.g., without limitation, tone), the SP 80 can cause the SP 84 to open. Conversely, by sending or impressing the signal 166 (e.g., without limitation, tone), the SP 80 can cause the SP 84 to close.

For example, a power line carrier (PLC) modulated tone can remotely control a generating module remotely controlled switch, such as 168 (Figure 5). As long as the receiver 164 hears the modulated tone, it closes the switch 168. If the modulated tone is lost or turned off for maintenance, then the switch 168 (or the isolation switch 182 of the SP 100 of Figure 7) isolates the corresponding DC EGM to prevent it from generating any external current/voltage and opens the string 210.

As shown in Figure 7, the SP 100 includes a power supply 274 that can receive power from an external power supply (switch 275 at positions A and D), such as 148 or 150 of Figure 6, from the main bus 270 (switch 275 at positions A and D) and/or from a corresponding local DC EGM (switch 275 at positions B and C) (see, also, the SP 84B of Figure 5 in which the power supply 274 is powered from terminals B and C).

### Example 38

The maintenance function of Example 37 can be selected from the group consisting of enabling a corresponding one of the DC EGMs 158,158A,8,8 or the SPs 80,84,84B,84C, and disabling a corresponding one of the DC EGMs 158,158A,8,8 or the SPs 80,84,84B,84C.

### Example 39

The maintenance function can be selected from the group consisting of enabling the corresponding combiner box 216 or inverter 220, and disabling the corresponding combiner box 216 or inverter 220. For example, a protector operatively associated with the transmitter (Tx) 162 can include a corresponding receiver, as is shown with the SPs 224,226,228,230 of Figure 6.

### Example 40

The various SPs 80,84,84B,84C,224,226,228,230 of Figures 5 and 6, like the SP 100 of Figure 7, can be structured to report a fault state or health of the corresponding string 210,232,234 to a remote location, such as 200 (shown in phantom line drawing) of Figure 7. The remote location 200 can be structured to determine fault location based on which of the various SPs reported the fault state or did not report the corresponding string heath. Also, as shown with the SP 100 of Figure 7, the SPs can include a number of local status indicators 268, such as LEDs, to locally indicate alarms or fault states of the corresponding string, combiner box, inverter or DC EGM.

### Example 41

Figure 6 shows a system, such as the example string array configuration 276, including the second (opposite) combiner box 142. This includes the combiner boxes 142,144 at each end for multiple strings, such as 232,234. The second opposite combiner box 142 addresses parallel faults. Power is available within the combiner boxes 142,144 (e.g., from an external source 148,150; from bus voltage of the main bus 270). This reconfigures the conductor topology so that there is the second combiner box 142 with plural SPs, such as 84A,228,230 and 80A,224,226 at each end of the strings, such as 278,232,234. The second opposite combiner box 142 can provide a locally powered and environmentally protected enclosure for a cluster of SPs, such as 84A,228,230. This mitigates many parallel faults with a single return path 280 for the plural strings 278,232,234,88',284,286 in contrast to the known alternative return path (e.g., without limitation, along a grounded module frame or next to the positive power line) 288 (shown in phantom line drawing) for each of those strings. Hence, the six example alternative return paths 288 (shown in phantom line drawing) for the six example strings 278,232,234,88',284,286 are preferably eliminated.

The example system of Figure 6 includes the first combiner box 144, the second (e.g., opposite) combiner box 142, and the example plural strings 88',284,286,278,232,234 extending between the first and second combiner boxes 144,142. Each of these strings includes a plurality of DC EGMs 8 electrically connected in series to form a first end 290 and an opposite second end 292, a power line 294 electrically connected to one of the DC EGMs 8 at the first end 290, a return line 296,298 electrically connected (through a corresponding SP) to another one of the plurality of DC EGMs at the opposite second end 292, a first SP 80A,224,226,84 in the power line 294 of each of the strings, and a second SP 84A,228,230,80 in the return line 296,298 of each of the strings. For each of the strings, one of the first SPs 80A,224,226,84 and the second SPs 84A,228,230,80 includes a number of the over current protector routine 112, the arc fault protector routine 114, the reverse current protector routine 116 and the ground fault protector routine 118 of Figure 7; and the other one of such first SPs and such second SPs includes a number of the over current protector routine 112, the arc fault protector routine 114, the reverse current protector routine 116, the ground fault protector routine 118, and a remotely controlled switch (S) 168 (Figure 5) in series with the power line 294 or the return line 296,298, respectively. For the example strings 88',284,286, the second combiner box 142 is located at the first end 290 and the first combiner box 144 is located at the opposite second end 292. For the example strings 278,232,234, the power line 146 is located in the first combiner box 144, and the return line 298 is located in the second combiner box 142. For the example strings 88',284,286, the power line 146 is located in the second combiner box 142, and the return line 296 is located in the first combiner box 144. This distributes the power lines and the return lines between the two combiner boxes 142,144, in order that the SPs can obtain power (not shown) from the main DC bus 270.

### Example 42

The example SPs 80A,224,226 located in the first combiner box 144 are powered from the power line 146 of the main bus 270 within the first combiner box 144. The example SPs 84 located in the second combiner box 142 are powered from the power line 146 of the main bus 270 within the second combiner box 142. The other SPs, such as 80,84A are powered from respective external power supplies 148,150.

### Example 43

The second SPs, such as 84A,228,230 in the second combiner box 142 can sense, for example, arcs at the opposite end 292 of the strings 278,232,234 to provide full isolation/mitigation. The SPs 228,230 can also transmit a different signal 240,242 (e.g., without limitation, a different modulated tone) back to the other SPs 224,226, respectively, to indicate that no fault is present (e.g., the corresponding string health is good).

### Example 44

Figure 7 shows the example SP 100 for a string (e.g., without limitation, having a string voltage of about 24 VDC to about 600 VDC at greater than about 7 A maximum) or a DC EGM. For example, various protection/alarm functions can be provided by the over current protector routine 112, the arc fault (e.g., series; parallel) protector routine 114, the reverse current protector routine 116, the ground fault protector routine 118, as well as string performance (e.g., open; low output). The example SP 100 includes the isolation switch 182 controlled by the processor 106 (e.g., without limitation, a microprocessor).

Preferably, the number of local status indicators 268 and/or the communication port 110 are also provided for remote monitoring and alarms.

### Example 45

As an alternative to the example isolation switch 182, the SP 100 can output a trip/control signal to, for example and without limitation, an external DC switch, disconnect or shunt trip circuit breaker.

### Example 46

As another alternative, the isolation switch 182 can be a double pole switch (e.g., 160 of Figure 5), which can open both the positive bus (e.g., between terminals B and A as shown in Figures 5 and 7) and also the negative/return bus (e.g., BUS- between terminals C and D as shown in Figure 5), which is shown outside of the SP 100, in order to avoid high voltage potential differences inside the device. In Figure 5, another isolation switch 182' is between terminals C and D. In Figure 7, the points C and D are shown in phantom line drawing for reference only.

### Example 47

Referring to Figure 8, the remote SP 84 is with the DC EGM 8 at the remote end 122 of the string 88". This remote SP 84 can be integral with or external to a junction box (not shown) of the DC EGM 8 and obtain power therefrom. The SPs 80,84 can address, among other faults, parallel faults as shown.

### Example 48

Figure 9 shows series detection and protection at a combiner box 300 by SP 302. Alternatively, it will be appreciated that the SP 302 can be provided at the inverter 178 or load (not shown) of Figure 3. This relatively simple solution of Figure 9 does not address all types of parallel faults. The string 304 includes a plurality of DC EGMs 8 electrically connected in series to form a first end 306 and a remote second end 308. A power line 309 is electrically connected to one of the DC EGMs 8 at the first end 306. A return line 310 is electrically connected to another one of the DC EGMs 8 at the remote second end 308. The SP 302 is in the power line 309 of the string 304. In a similar manner as the SP 100 of Figure 7, the SP 302 includes a number of the arc fault protector routine 114, the reverse current protector routine 116 and the ground fault protector routine 118 of Figure 7. Although not shown, the SP 302 can be located in or at a DC/DC converter or a DC/AC inverter. The SP 302 can include the over current protector routine 112, or can be operatively associated with another over current protector (e.g., without limitation, circuit interrupter; circuit breaker; fuse) electrically connected in series with the SP 302 in the power line 309.

### Example 49

As another alternative, the SP 302 can be located at the first end 306 with one of the DC EGMs 8. This configuration is advantageous for retrofit applications, such that the electrician does not have to go into the combiner box 300 to install a protective device or rewire. Instead, the electrician just plugs the SP 302 in at the DC EGM 8 at the first end 306 of the string 304.

### Example 50

In the same or similar manner as the SP 100 of Figure 7, the SP 302 is structured to monitor or report current flowing in the power line 309 of the string 304.

The disclosed strings 88,90,134 of Figure 3 improve, for example and without limitation, short circuit and arcing mitigation. These protect the return lines 86,98 and protect the power circuit from a single occurrence of, for example and without limitation, a short or arcing event, such as 124, between positive and negative conductors.

The disclosed SPs 80,84 and the protector 196 protect the relatively higher current, high voltage conductors between the string array and the inverter 178 and can be commanded to turn off under a plurality of fault scenarios that can develop in the power circuits of the string array. Such SPs and protector can be located in or at any component (e.g., without limitation, circuit breaker; combiner box; remote combiner box; DC EGM; inverter; central inverter; string inverter; converter; module converter; module junction box; disconnect) of the PV systems, strings and arrays disclosed herein.

The second combiner box 142 and the main bus 270 of Figure 6 reduce conductors that return to a single combiner box (e.g., 24 of Figure 2A) and reduce the potential for shorted conductors.

While specific embodiments of the disclosed concept have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of the disclosed concept which is to be given the full breadth of the claims appended and any and all equivalents thereof.

The invention may be summarized as follows:
1. A string (304) comprising:
   a plurality of direct current electrical generating modules (8) electrically connected in series to form a first end (306) and a remote second end (308);
   a power line (309) electrically connected to one of said plurality of direct current electrical generating modules at the first end;
   a return line (310) electrically connected to another one of said plurality of direct current electrical generating modules at the remote second end; and
   a string protector (302) in the power line of said string, said string protector comprising a number of an arc fault protector (114), a reverse current protector (116) and a ground fault protector (118).
2. The string (304) of 1 wherein said string protector is located at the first end (306) with one of said plurality of direct current electrical generating modules.
3. The string (304) of 1 or2 wherein said string protector is structured (110) to monitor or report current flowing in the power line of said string.
4. The string (304) of one of 1 - 3 wherein said string protector further comprises an over current protector (112).
5. A string (90) comprising:
   a plurality of direct current electrical generating modules (8) electrically connected in series to form a first end (92) and a remote second end (94);
   a power line (96) electrically connected to one of said plurality of direct current electrical generating modules at the first end;
   a return line (98) electrically connected to another one of said plurality of direct current electrical generating modules at the remote second end; and
   a string protector (100) in the return line of said string at the remote second end, said string protector comprising a number of an over current protector (112), an arc fault protector (114), a reverse current protector (116) and a ground fault protector (118).
6. The string (90) of 5 wherein said string protector is structured (110) to monitor or report current flowing in the return line of said string.
7. The string (90) of 5 or 6 wherein said string protector is located at the remote second end (94) with one (8) of said plurality of direct current electrical generating modules.
8. The string (90) of any one of 5 - 7 wherein a diode (101) is disposed in the power line at the first end of the string to block reverse current, back-feed current or current sourced from the first end toward the second end of the string.
9. A string (88;210;278;282;88") comprising:
   a plurality of direct current electrical generating modules (8) electrically connected in series to form a first end (120) and a remote second end (122);
   a power line (82) electrically connected to one of said plurality of direct current electrical generating modules at the first end;
   a return line (86) electrically connected to another one of said plurality of direct current electrical generating modules at the remote second end;
   a first string protector (80) in the power line of said string; and
   a second string protector (84) in the return line of said string at the remote second end,
   wherein one of said first string protector and said second string protector comprises a number of an over current protector (112), an arc fault protector (114), a reverse current protector (116) and a ground fault protector (118), and
   wherein the other one of said first string protector and said second string protector comprises a number of an over current protector (112), an arc fault protector (114), a reverse current protector (116), a ground fault protector (118), and a remotely controlled switch (168) in series with the power line or the return line.
10. The string (88) of 9 wherein said second string protector is disposed at the remote second end (122).
11. The string (88) of 9 or 10 wherein at least one of said first string protector and said second string protector is structured (110) to monitor or report current flowing in the power line or the return line of said string.
12. The string (278;282) of any one of 9 - 11 wherein said second string protector (84A) is located in a remote combiner box (142:144).
13. The string (278;282) of any one of 9 - 12 wherein one of said first string protector and said second string protector is powered from a main direct current bus (270) of a first combiner box and a second combiner box, respectively.
14. The string (278;282) of any one of 9 - 13 wherein one of said first string protector and said second string protector is powered from a power supply (148;150) external to a first combiner box and a second combiner box, respectively.
15. The string (278;282) of any one of 9― 14 wherein the second string protector is operatively associated with said another one of said plurality of direct current electrical generating modules at the remote second end (292).
16. The string (210;88") of 15 wherein the second string protector (84B;84) is powered by said another one of said plurality of direct current electrical generating modules (158;8) at the remote second end.
17. The string (88") of 16 wherein said one of said plurality of direct current electrical generating modules at the first end is a first direct current electrical generating module (88); wherein another one of said plurality of direct current electrical generating modules is a second direct current electrical generating module (8A); wherein said another one of said plurality of direct current electrical generating modules at the remote second end is a third direct current electrical generating module (8); wherein said third direct current electrical generating module includes a first power terminal (152), and a second power terminal (154) electrically connected to the return line (155); wherein said second direct current electrical generating module includes a first power terminal (158), and a second power terminal (160) electrically connected to the first power terminal of said third direct current electrical generating module; and wherein said second string protector (84) is powered by said third direct current electrical generating module (8).
18. The string (88") of 17 wherein said second string protector is structured to interrupt at least one of the first power terminal and the second power terminal of said third direct current electrical generating module.
19. The string (88") of 17 wherein said second string protector (84B) is structured to interrupt both of the first power terminal (152A) and the second power terminal (154A) of said third direct current electrical generating module (158).
20. The string (210) of any one of 9 - 19 wherein said second string protector (84B) is structured (160) to isolate said another one (158) of said plurality of direct current electrical generating modules from said string responsive to at least one of the over current protector, the arc fault protector, the reverse current protector and the ground fault protector.
21. The string (210) of 20 wherein the second string protector is powered by said another one of said plurality of direct current electrical generating modules at the remote second end regardless whether said another one of said plurality of direct current electrical generating modules is isolated from said string.
22. The string (210) of 20 wherein the second string protector is structured (102;161) to measure current and voltage generated by said another one of said plurality of direct current electrical generating modules regardless whether said another one of said plurality of direct current electrical generating modules is isolated from said string.
23. The string (210) of any one of 9 - 22 wherein said first string protector and said second string protector are structured to trip open the power line and the return line, respectively, of said string; and wherein said first string protector and said second string protector are further structured (162,164) to communicate between each other such that a trip by one of said first string protector and said second string protector causes a trip by the other one of said first string protector and said second string protector.
24. The string (210) of any one of 9 - 23 wherein one of said first string protector and said second string protector is structured to trip open the power line and the return line, respectively, of said string; wherein the other one (84) of said first string protector and said second string protector comprises said remotely controlled switch (168); and wherein said first string protector and said second string protector are further structured (162,164) to communicate between each other such that said trip causes said remotely controlled switch to trip open one of the power line and the return line, such that both of the power line and the return line are opened.
25. A string (180) comprising:
   a plurality of direct current electrical generating modules (8C) electrically connected in series to form a first end (184) and a remote second end (186);
   a power line (188) electrically connected to one of said plurality of direct current electrical generating modules at the first end;
   a return line (190) electrically connected to another one of said plurality of direct current electrical generating modules at the remote second end;
   a number of first protectors (192;302) operatively associated with the power line of said string; and
   a plurality of second string protectors (170), each of said plurality of second string protectors being at a corresponding one of said plurality of direct current electrical generating modules,
   wherein each of said number of first protectors and said plurality of second string protectors comprises a number of an over current protector, an arc fault protector, a reverse current protector and a ground fault protector.
26. The string (180) of 25 wherein said plurality of direct current electrical generating modules are photovoltaic electrical generating modules (8C); and wherein said each of said plurality of second string protectors is structured (102;161;106) to monitor photovoltaic electrical generating module current, voltage and illumination at the corresponding one of said photovoltaic electrical generating modules.
27. The string (180) of 25 or 26 wherein said each of said plurality of second string protectors is structured (182; 160) to isolate the corresponding one of said plurality of direct current electrical generating modules from said string responsive to at least one of the over current protector, the arc fault protector, the reverse current protector and the ground fault protector.
28. The string (180) of 27 wherein the corresponding one of said plurality of direct current electrical generating modules includes a junction box (156A); and wherein one (84C) of said plurality of second string protectors is integral to said junction box.
29. The string (180) of 27 wherein the corresponding one of said plurality of direct current electrical generating modules includes a junction box (156); and wherein one (84B) of said plurality of second string protectors is operatively associated with said junction box.
30. The string (180) of any one of 25 - 29 wherein said number of first protectors (192;302) are selected from the group consisting of: a third string protector (192;193) in the power line (188) between one of said plurality of direct current electrical generating modules and a direct current power bus (56), a fourth protector (196) in a main feed (198) between said direct current power bus and an inverter (178), and a fifth string protector (302) in a combiner box (300).
31. The string (180) of any one of 25 - 30 wherein each of said plurality of second string protectors is structured (110) to communicate a status thereof to a remote location (200), which can determine a status of each of said plurality of direct current electrical generating modules.
32. The string (180) of 31 wherein a number of the number of first protectors (196) operatively associated with the power line of said string is structured to communicate (110) a status thereof to said remote location, which can further determine a status of said string.
33. A system (276) comprising:
   a first combiner box (144);
   a second combiner box (142);
   a plurality of strings (88',284,286,278,232,234) extending between said first combiner box and said second combiner box, each string of a plurality of said plurality of strings comprising:
      a plurality of direct current electrical generating modules (8) electrically connected in series to form a first end (292) and an opposite second end (294),
      a power line (294) electrically connected to one of said plurality of direct current electrical generating modules at the first end,
      a return line (296) electrically connected to another one of said plurality of direct current electrical generating modules at the opposite second end,
      a first string protector (80) in the power line of said each string, and
      a second string protector (84) in the return line of said each string at the opposite second end,
      wherein one of said first string protector and said second string protector comprises a number of an over current protector (112), an arc fault protector (114), a reverse current protector (116) and a ground fault protector (118), and
      wherein the other one of said first string protector and said second string protector comprises a number of an over current protector (112), an arc fault protector (114), a reverse current protector (116), a ground fault protector (118) and a remotely controlled switch (168) in series with the power line or the return line,
      wherein, for a plurality of said plurality of strings, one (144) of said first and second combiner boxes is located at the first end,
      wherein, for a plurality of said plurality of strings, the other one (142) of said first and second combiner boxes is located at the opposite second end,
      wherein the power line of a plurality of said plurality of strings is located in the first combiner box, and
      wherein the return line of the last said plurality of said plurality of strings is located in the second combiner box.
34. The system (276) of 33 wherein a plurality of the first string protector and the second string protector located in the first combiner box are powered from a direct current bus voltage (146) within the first combiner box; and wherein a plurality of the first string protector and the second string protector located in the second combiner box are powered from said direct current bus voltage within the second combiner box.
35. A string (210) comprising:
   a plurality of direct current electrical generating modules (158,158A,8,8) electrically connected in series to form a first end (214) and a remote second end (222);
   a power line (82) electrically connected to one of said plurality of direct current electrical generating modules at the first end;
   a return line (86) electrically connected to another one of said plurality of direct current electrical generating modules at the remote second end; and
   a plurality of string protectors (80,84), each of a plurality of said plurality of string protectors being operatively associated with at least one of the power line, the return line at the remote second end and one of said plurality of direct current electrical generating modules, each of said plurality of said plurality of string protectors comprising a number of an over current protector (112), an arc fault protector (114), a reverse current protector (116) and a ground fault protector (118),
   wherein one (80) of said plurality of string protectors is structured to determine a normal state of said string and responsively transmit (162) a signal (166), and
   wherein another one (84) of said plurality of string protectors is structured to receive (164) said signal and responsively maintain series electrical connection of a corresponding one of said plurality of direct current electrical generating modules with at least another one of said plurality of direct current electrical generating modules.
36. The string (210) of 35 wherein said one of said plurality of string protectors is located adjacent said one of said plurality of direct current electrical generating modules at the first end; and wherein said another one of said plurality of string protectors is located adjacent said another one of said plurality of direct current electrical generating modules at the remote second end.
37. The string (210) of 35 or 36 wherein said signal is selected from the group consisting of a wireless signal, a wired signal, and a power line carrier signal in a power conductor between a plurality of said plurality of direct current electrical generating modules.
38. The string (210) of any one of 35 ― 37 wherein said another one of said plurality of string protectors is structured, when not receiving said signal, to responsively isolate said corresponding one of said plurality of direct current electrical generating modules from at least said another one of said plurality of direct current electrical generating modules.
39. The string (210) of 35 - 38 wherein a plurality (224,226,228,230) of said plurality of string protectors are structured to determine a normal state of said string and responsively transmit a corresponding signal (236,238,240,242) to others of said plurality of string protectors.
40. The string (210) of 39 wherein each of said plurality of said plurality of string protectors are operatively associated with one of said plurality of direct current electrical generating modules (8), a combiner box (142,144) or an inverter (220).
41. The string (210) of any one of 35 - 40 wherein said signal includes an active state corresponding to the normal state of said string and an inactive state corresponding to a fault state of said string; and wherein said another one of said plurality of string protectors is structured to receive said signal having the normal state and responsively maintain series electrical connection of the corresponding one of said plurality of direct current electrical generating modules with at least said another one of said plurality of direct current electrical generating modules, and is further structured upon not receiving said signal having the normal state to responsively electrically disconnect the corresponding one of said plurality of direct current electrical generating modules from at least said another one of said plurality of direct current electrical generating modules.
42. The string (210) of any one of 35 - 41 wherein said signal includes an active state corresponding to the normal state of said string and an inactive state corresponding to a fault state of said string; and wherein absence of said signal or attenuation of said signal indicates a fault of said string.
43. The string (210) of any one of 35 - 42 wherein a plurality of said plurality of string protectors are structured to employ said signal for a maintenance function.
44. The string (210) of 43 wherein said maintenance function is selected from the group consisting of enabling a corresponding one of said plurality of direct current electrical generating modules or said plurality of string protectors, and disabling a corresponding one of said plurality of direct current electrical generating modules or said plurality of string protectors.
45. The string (210) of 43 wherein said maintenance function is selected from the group consisting of enabling a corresponding combiner box (216) or inverter (220), and disabling a corresponding combiner box (216) or inverter (220).
46. The string (210) of any one of 35 - 45 wherein a plurality of said plurality of string protectors are structured (110) to report a fault state of said string or health of said string to a remote location (200); and wherein said remote location is structured to determine fault location based on which of said plurality of said plurality of string protectors reported said fault state or did not report said heath.

### REFERENCE NUMERICAL LIST

- 2: parallel string
- 4: parallel string
- 6: parallel string
- 8: series-connected direct current (DC) electrical generating module (e.g., PV generating module)
- 8A: generating module
- 8B: generating module
- 8C: generating module
- 10: protective device
- 12: positive conductor
- 14: main DC bus
- 16: combiner box
- 20: DC power generating circuit
- 22: protective device
- 24: combiner box
- 26: string
- 28: string
- 30: string
- 32: string
- 34: remote short with feed open fault
- 36: return conductor
- 38: feed short with remote open fault
- 40: return conductor
- 42: pinch short fault
- 44: return conductor
- 46: position A
- 48: positive polarity broken conductor
- 50: position B
- 51: arc
- 52: negative polarity broken conductor
- 54: position A
- 56: main bus
- 58: position B
- 60: position C
- 62: interconnecting conductor
- 64: position A
- 66: position B
- 68: IB
- 70: position C
- 72: negative bus
- 74: IC
- 80: first string protector (e.g., without limitation, AFCI)
- 80A: first string protector
- 82: positive feed conductor
- 84: second string protector (e.g., without limitation, AFCI)
- 84A: second string protector
- 84B: string protector
- 84C: SP
- 86: return line
- 88: string
- 88': string
- 88": string
- 90: string
- 92: first end
- 94: remote second end
- 96: power line
- 98: return line
- 99: string protector (e.g., without limitation, AFCI)
- 100: string protector (e.g., without limitation, AFCI)
- 101: diode
- 102: current sensor
- 102': current sensor
- 104: analog front end
- 104': analog front end
- 106: processor (e.g., without limitation, microprocessor)
- 108: sensed string current
- 108': sensed string return current
- 110: communication port
- 112: over current protector routine
- 114: arc fault protector routine
- 116: reverse current protector routine
- 118: ground fault protector routine
- 120: first end
- 122: remote second end
- 124: fault or parallel arc
- 126: arc
- 128: arc
- 130: position A
- 132: position B
- 134: string
- 136: IB
- 138: position C
- 140: IC
- 142: second combiner box
- 144: first combiner box
- 146: main direct current bus or power line
- 148: power supply
- 150: power supply
- 152: first power terminal
- 152A: first power terminal
- 154: second power terminal
- 154A: second power terminal
- 155: return line
- 156: junction box
- 156A: junction box
- 158: direct current electrical generating module (DC EGM)
- 158A: DC EGM
- 160: double pole switch
- 161: divider
- 162: transmitter (Tx)
- 164: receiver (Rx)
- 166: signal
- 168: remotely controlled switch (S)
- 170: string protectors
- 172: position A
- 174: position B
- 176: position C
- 178: inverter
- 180: string
- 182: isolation switch
- 182': isolation switch
- 184: first end
- 186: remote second end
- 188: power line
- 190: return line
- 192: number of first protectors
- 193: main DC protector (AFCI)
- 194: circuit conductors
- 195: disconnect switch
- 196: protector
- 198: main feed
- 200: remote location
- 202: string
- 204: string
- 206: string
- 208: system
- 210: string
- 212: short circuit event
- 214: first end
- 216: combiner box
- 218: main bus
- 220: inverter or load
- 222: remote second end
- 224: SP
- 226: SP
- 228: SP
- 230: SP
- 232: string
- 234: string
- 236: signal
- 238: signal
- 240: signal
- 242: signal
- 244: transmitter (TX)
- 246: tone (A2)
- 248: receiver (RX)
- 250: transmitter (TX)
- 252: tone (A1)
- 254: receiver (RX)
- 256: transmitter (TX)
- 258: tone (B2)
- 260: receiver (RX)
- 262: transmitter (TX)
- 264: tone (B1)
- 266: receiver (RX)
- 268: number of status indicators
- 270: common main DC bus
- 272: general tone
- 274: power supply
- 275: switch
- 276: string array configuration
- 278: string
- 280: single return path
- 284: string
- 286: string
- 288: alternative return paths
- 290: first end
- 292: opposite second end
- 294: power line
- 296: return line
- 298: return line
- 300: combiner box
- 302: SP
- 304: string
- 306: first end
- 308: remote second end
- 309: power line
- 310: return line

## Claims

**1.** A string (304) comprising:
a plurality of direct current electrical generating modules (8) electrically connected in series to form a first end (306) and a remote second end (308);
a power line (309) electrically connected to one of said plurality of direct current electrical generating modules at the first end;
a return line (310) electrically connected to another one of said plurality of direct current electrical generating modules at the remote second end; and
a string protector (302) in the power line of said string, said string protector comprising a number of an arc fault protector (114), a reverse current protector (116) and a ground fault protector (118).

**2.** The string (304) of Claim 1 wherein said string protector is located at the first end (306) with one of said plurality of direct current electrical generating modules and/or wherein said string protector is structured (110) to monitor or report current flowing in the power line of said string, and/or wherein said string protector further comprises an over current protector (112).

**3.** A string (90) comprising:
a plurality of direct current electrical generating modules (8) electrically connected in series to form a first end (92) and a remote second end (94);
a power line (96) electrically connected to one of said plurality of direct current electrical generating modules at the first end;
a return line (98) electrically connected to another one of said plurality of direct current electrical generating modules at the remote second end; and
a string protector (100) in the return line of said string at the remote second end, said string protector comprising a number of an over current protector (112), an arc fault protector (114), a reverse current protector (116) and a ground fault protector (118).

**4.** The string (90) of Claim 3 wherein said string protector is structured (110) to monitor or report current flowing in the return line of said string, and/or wherein said string protector is located at the remote second end (94) with one (8) of said plurality of direct current electrical generating modules, and/or wherein a diode (101) is disposed in the power line at the first end of the string to block reverse current, back-feed current or current sourced from the first end toward the second end of the string.

**5.** A string (88;210;278;282;88") comprising:
a plurality of direct current electrical generating modules (8) electrically connected in series to form a first end (120) and a remote second end (122);
a power line (82) electrically connected to one of said plurality of direct current electrical generating modules at the first end;
a return line (86) electrically connected to another one of said plurality of direct current electrical generating modules at the remote second end;
a first string protector (80) in the power line of said string; and
a second string protector (84) in the return line of said string at the remote second end,
wherein one of said first string protector and said second string protector comprises a number of an over current protector (112), an arc fault protector (114), a reverse current protector (116) and a ground fault protector (118), and
wherein the other one of said first string protector and said second string protector comprises a number of an over current protector (112), an arc fault protector (114), a reverse current protector (116), a ground fault protector (118), and a remotely controlled switch (168) in series with the power line or the return line.

**6.** The string (88) of Claim 5 wherein said second string protector is disposed at the remote second end (122), and/or wherein at least one of said first string protector and said second string protector is structured (110) to monitor or report current flowing in the power line or the return line of said string, and/or wherein said second string protector (84A) is located in a remote combiner box (142;144), and/or wherein one of said first string protector and said second string protector is powered from a main direct current bus (270) of a first combiner box and a second combiner box, respectively, and/or wherein one of said first string protector and said second string protector is powered from a power supply (148;150) external to a first combiner box and a second combiner box, respectively.

**7.** The string (278;282) of Claim 5 or 6, wherein the second string protector is operatively associated with said another one of said plurality of direct current electrical generating modules at the remote second end (292), wherein the second string protector (84B;84) is optionally powered by said another one of said plurality of direct current electrical generating modules (158;8) at the remote second end, and/or wherein optionally said one of said plurality of direct current electrical generating modules at the first end is a first direct current electrical generating module (88); wherein another one of said plurality of direct current electrical generating modules is a second direct current electrical generating module (8A); wherein said another one of said plurality of direct current electrical generating modules at the remote second end is a third direct current electrical generating module (8); wherein said third direct current electrical generating module includes a first power terminal (152), and a second power terminal (154) electrically connected to the return line (155); wherein said second direct current electrical generating module includes a first power terminal (158), and a second power terminal (160) electrically connected to the first power terminal of said third direct current electrical generating module; and wherein said second string protector (84) is powered by said third direct current electrical generating module (8), wherein said second string protector is optionally structured to interrupt at least one of the first power terminal and the second power terminal of said third direct current electrical generating module, and/or wherein said second string protector (84B) is optionally structured to interrupt both of the first power terminal (152A) and the second power terminal (154A) of said third direct current electrical generating module (158).

**8.** The string (210) of Claim 5 wherein said second string protector (84B) is structured (160) to isolate said another one (158) of said plurality of direct current electrical generating modules from said string responsive to at least one of the over current protector, the arc fault protector, the reverse current protector and the ground fault protector, wherein the second string protector is optionally powered by said another one of said plurality of direct current electrical generating modules at the remote second end regardless whether said another one of said plurality of direct current electrical generating modules is isolated from said string, and/or wherein the second string protector is optionally structured (102:161) to measure current and voltage generated by said another one of said plurality of direct current electrical generating modules regardless whether said another one of said plurality of direct current electrical generating modules is isolated from said string.

**9.** The string (210) of Claim 5 wherein said first string protector and said second string protector are structured to trip open the power line and the return line, respectively, of said string; and wherein said first string protector and said second string protector are further structured (162,164) to communicate between each other such that a trip by one of said first string protector and said second string protector causes a trip by the other one of said first string protector and said second string protector, and/or
wherein one of said first string protector and said second string protector is structured to trip open the power line and the return line, respectively, of said string; wherein the other one (84) of said first string protector and said second string protector comprises said remotely controlled switch (168); and wherein said first string protector and said second string protector are further structured (162,164) to communicate between each other such that said trip causes said remotely controlled switch to trip open one of the power line and the return line, such that both of the power line and the return line are opened.

**10.** A string (180) comprising:
a plurality of direct current electrical generating modules (8C) electrically connected in series to form a first end (184) and a remote second end (186);
a power line (188) electrically connected to one of said plurality of direct current electrical generating modules at the first end;
a return line (190) electrically connected to another one of said plurality of direct current electrical generating modules at the remote second end;
a number of first protectors (192;302) operatively associated with the power line of said string; and
a plurality of second string protectors (170), each of said plurality of second string protectors being at a corresponding one of said plurality of direct current electrical generating modules,
wherein each of said number of first protectors and said plurality of second string protectors comprises a number of an over current protector, an arc fault protector, a reverse current protector and a ground fault protector.

**11.** The string (180) of Claim 11, wherein said plurality of direct current electrical generating modules are photovoltaic electrical generating modules (8C); and wherein said each of said plurality of second string protectors is structured (102;161;106) to monitor photovoltaic electrical generating module current, voltage and illumination at the corresponding one of said photovoltaic electrical generating modules, and/or
wherein optionally said each of said plurality of second string protectors is structured (182;160) to isolate the corresponding one of said plurality of direct current electrical generating modules from said string responsive to at least one of the over current protector, the arc fault protector, the reverse current protector and the ground fault protector, and/or
wherein optionally the corresponding one of said plurality of direct current electrical generating modules includes a junction box (156A); and wherein one (84C) of said plurality of second string protectors is integral to said junction box, and/or
wherein optionally the corresponding one of said plurality of direct current electrical generating modules includes a junction box (156); and wherein one (84B) of said plurality of second string protectors is operatively associated with said junction box, and/or
wherein optionally said number of first protectors (192;302) are selected from the group consisting of: a third string protector (192;193) in the power line (188) between one of said plurality of direct current electrical generating modules and a direct current power bus (56), a fourth protector (196) in a main feed (198) between said direct current power bus and an inverter (178), and a fifth string protector (302) in a combiner box (300) and/or
wherein optionally each of said plurality of second string protectors is structured (110) to communicate a status thereof to a remote location (200), which can determine a status of each of said plurality of direct current electrical generating modules, and/or
wherein optionally a number of the number of first protectors (196) operatively associated with the power line of said string is structured to communicate (110) a status thereof to said remote location, which can further determine a status of said string.

**12.** A system (276) comprising:
a first combiner box (144);
a second combiner box (142);
a plurality of strings (88',284,286,278,232,234) extending between said first combiner box and said second combiner box, each string of a plurality of said plurality of strings comprising:
a plurality of direct current electrical generating modules (8) electrically connected in series to form a first end (292) and an opposite second end (294),
a power line (294) electrically connected to one of said plurality of direct current electrical generating modules at the first end,
a return line (296) electrically connected to another one of said plurality of direct current electrical generating modules at the opposite second end,
a first string protector (80) in the power line of said each string, and
a second string protector (84) in the return line of said each string at the opposite second end,
wherein one of said first string protector and said second string protector comprises a number of an over current protector (112), an arc fault protector (114), a reverse current protector (116) and a ground fault protector (118), and
wherein the other one of said first string protector and said second string protector comprises a number of an over current protector (112), an arc fault protector (114), a reverse current protector (116), a ground fault protector (118) and a remotely controlled switch (168) in series with the power line or the return line,
wherein, for a plurality of said plurality of strings, one (144) of said first and second combiner boxes is located at the first end,
wherein, for a plurality of said plurality of strings, the other one (142) of said first and second combiner boxes is located at the opposite second end,
wherein the power line of a plurality of said plurality of strings is located in the first combiner box, and
wherein the return line of the last said plurality of said plurality of strings is located in the second combiner box.

**13.** The system (276) of Claim 12 wherein a plurality of the first string protector and the second string protector located in the first combiner box are powered from a direct current bus voltage (146) within the first combiner box; and wherein a plurality of the first string protector and the second string protector located in the second combiner box are powered from said direct current bus voltage within the second combiner box.

**13.** A string (210) comprising:
a plurality of direct current electrical generating modules (158,158A,8,8) electrically connected in series to form a first end (214) and a remote second end (222);
a power line (82) electrically connected to one of said plurality of direct current electrical generating modules at the first end;
a return line (86) electrically connected to another one of said plurality of direct current electrical generating modules at the remote second end; and
a plurality of string protectors (80,84), each of a plurality of said plurality of string protectors being operatively associated with at least one of the power line, the return line at the remote second end and one of said plurality of direct current electrical generating modules, each of said plurality of said plurality of string protectors comprising a number of an over current protector (112), an arc fault protector (114), a reverse current protector (116) and a ground fault protector (118),
wherein one (80) of said plurality of string protectors is structured to determine a normal state of said string and responsively transmit (162) a signal (166), and
wherein another one (84) of said plurality of string protectors is structured to receive (164) said signal and responsively maintain series electrical connection of a corresponding one of said plurality of direct current electrical generating modules with at least another one of said plurality of direct current electrical generating modules.

**14.** The string (210) of Claim 13 wherein said one of said plurality of string protectors is located adjacent said one of said plurality of direct current electrical generating modules at the first end; and wherein said another one of said plurality of string protectors is located adjacent said another one of said plurality of direct current electrical generating modules at the remote second end, and/or
wherein optionally said signal is selected from the group consisting of a wireless signal, a wired signal, and a power line carrier signal in a power conductor between a plurality of said plurality of direct current electrical generating modules, and/or
wherein optionally said another one of said plurality of string protectors is structured, when not receiving said signal, to responsively isolate said corresponding one of said plurality of direct current electrical generating modules from at least said another one of said plurality of direct current electrical generating modules, and/or
wherein optionally a plurality (224,226,228,230) of said plurality of string protectors are structured to determine a normal state of said string and responsively transmit a corresponding signal (236,238,240,242) to others of said plurality of string protectors and/or
wherein optionally each of said plurality of said plurality of string protectors are operatively associated with one of said plurality of direct current electrical generating modules (8), a combiner box (142,144) or an inverter (220), and/or
wherein optionally said signal includes an active state corresponding to the normal state of said string and an inactive state corresponding to a fault state of said string; and wherein said another one of said plurality of string protectors is structured to receive said signal having the normal state and responsively maintain series electrical connection of the corresponding one of said plurality of direct current electrical generating modules with at least said another one of said plurality of direct current electrical generating modules, and is further structured upon not receiving said signal having the normal state to responsively electrically disconnect the corresponding one of said plurality of direct current electrical generating modules from at least said another one of said plurality of direct current electrical generating modules and/or
wherein optionally said signal includes an active state corresponding to the normal state of said string and an inactive state corresponding to a fault state of said string; and wherein absence of said signal or attenuation of said signal indicates a fault of said string.

**15.** The string (210) of Claim 13 wherein a plurality of said plurality of string protectors are structured to employ said signal for a maintenance function, and/or
wherein optionally said maintenance function is selected from the group consisting of enabling a corresponding one of said plurality of direct current electrical generating modules or said plurality of string protectors, and disabling a corresponding one of said plurality of direct current electrical generating modules or said plurality of string protectors and/or
wherein optionally said maintenance function is selected from the group consisting of enabling a corresponding combiner box (216) or inverter (220), and disabling a corresponding combiner box (216) or inverter (220), and/or
wherein optionally a plurality of said plurality of string protectors are structured (110) to report a fault state of said string or health of said string to a remote location (200); and wherein said remote location is structured to determine fault location based on which of said plurality of said plurality of string protectors reported said fault state or did not report said heath
